Europäisches Patentamt

European Patent Office

Office européen des brevets

(19)

(11) **EP 0 731 562 B1**

(12)

## FASCICULE DE BREVET EUROPEEN

(45) Date de publication et mention
de la délivrance du brevet:
**21.06.2000 Bulletin 2000/25**

(51) Int Cl.⁷: **H03K 19/00**

(21) Numéro de dépôt: **96410016.8**

(22) Date de dépôt: **05.03.1996**

(54) **Circuit logique à étage différentiel**

Logische Schaltung mit Differenzstufe

Logic circuit with a differential stage

(84) Etats contractants désignés:
**DE FR GB IT**

(30) Priorité: **07.03.1995 FR 9502840**

(43) Date de publication de la demande:
**11.09.1996 Bulletin 1996/37**

(73) Titulaire: **STMicroelectronics S.A.**
**94250 Gentilly (FR)**

(72) Inventeurs:
• **Belot, Didier**
**38140 Rives (FR)**
• **Dugoujon, Laurent**
**38660 Saint Bernard Du Touvet (FR)**

(74) Mandataire: **de Beaumont, Michel**
**1bis, rue Champollion**
**38000 Grenoble (FR)**

(56) Documents cités:
**EP-A- 0 249 541      EP-A- 0 493 150**
**EP-A- 0 544 362      WO-A-93/18587**
**US-A- 4 791 326**

## Description

La présente invention concerne les circuits logiques du type comprenant des étages amplificateurs fonctionnant en régime linéaire, en particulier des étages amplificateurs différentiels, tels que les circuits logiques à émetteurs couplés (ECL), à sources couplées (SCL) ou plus généralement en mode couplé (CML).

Les circuits ECL sont parmi les circuits logiques les plus rapides. Pour atteindre une vitesse de fonctionnement élevée, ces circuits sont conçus de façon telle que leurs transistors bipolaires n'entrent jamais en régime de saturation.

Pour éviter la saturation des transistors, ils sont montés en étages différentiels, c'est pourquoi on utilise la terminologie "émetteurs couplés". Ainsi les signaux traités par les circuits ECL sont le plus souvent différentiels et chaque composante différentielle est appliquée à une entrée respective d'un étage différentiel.

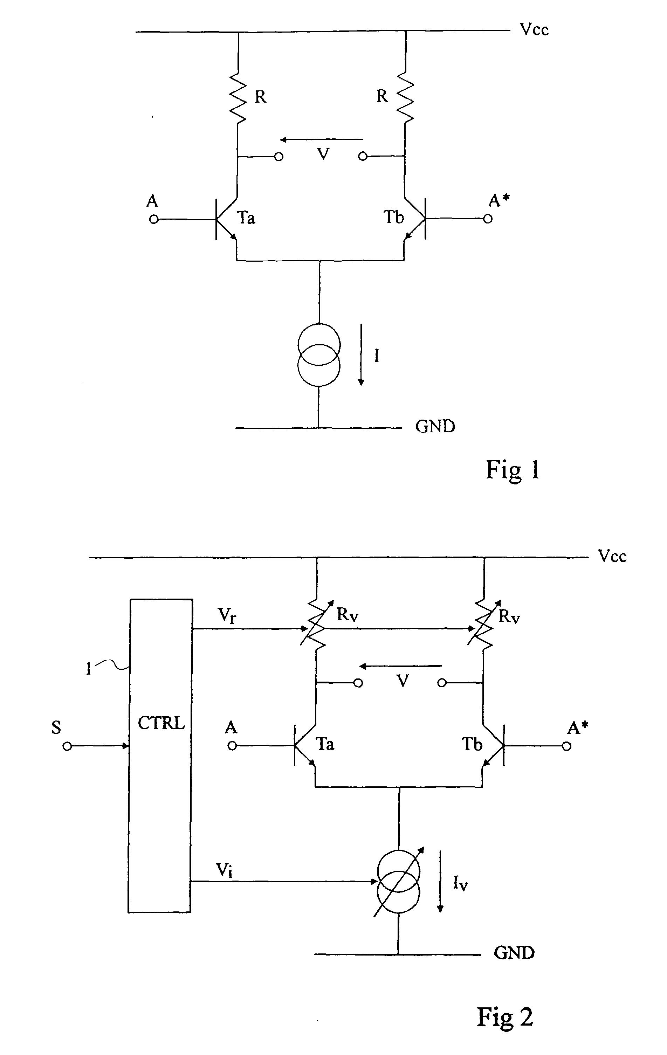

La figure 1 représente un étage différentiel à transistors bipolaires (Ta, Tb) pouvant servir d'inverseur ECL. Les collecteurs des transistors Ta et Tb sont reliés à un potentiel haut Vcc par des résistances de charge R respectives et une source de courant de polarisation I relie à la masse GND les émetteurs des transistors Ta et Tb. L'entrée différentielle A-A∗ de l'amplificateur est constituée des deux bases des transistors Ta et Tb et la sortie différentielle V est prise entre les collecteurs de ces transistors.

Les signaux ECL ont une faible excursion, c'est-à-dire que la différence de potentiel entre l'état haut et l'état bas d'une composante d'un signal ECL est faible. Cette faible excursion, de l'ordre de 0,5 V, contribue à augmenter la rapidité du circuit logique en diminuant l'énergie de charge et de décharge de capacités parasites.

La rapidité des circuits logique est essentiellement limitée par les capacités parasites des transistors bipolaires. Le circuit de collecteur présente une constante de temps inversement proportionnelle au courant de collecteur. Pour augmenter la rapidité, il est donc nécessaire d'utiliser des courants importants. Les résistances de collecteur ont alors une faible valeur pour limiter à la valeur souhaitée l'excursion du signal ECL. Aussi, un inconvénient majeur des circuits ECL est leur importante consommation de puissance due au fait que ces courants importants, délivrés par des sources de courant, sont toujours consommés par l'une ou l'autre branche d'un étage différentiel.

Certains circuits ECL sont prévus pour fonctionner à plusieurs fréquences, par exemple dans certains circuits de transmission de données en mode asynchrone (ATM) ils travaillent à des débits de 155 et 622 Mégabits par seconde (norme ITU I-432).

Un circuit prévu pour le plus fort débit présente, pour les raisons susmentionnées, une consommation de puissance élevée qui est injustifiée aux faibles débits.

Une solution classique pour limiter la consommation aux faibles débits consiste à adapter les courants délivrés par les sources aux débits de transmission. Pour conserver la même excursion en tension, les résistances de charge sont remplacées par des diodes. Ainsi, une même excursion d'environ 0,7 V est conservée pour divers courants. Cette excursion n'est toutefois pas compatible avec la technologie ECL, et elle est fortement dépendante de la température. En outre, la présence de diodes augmente les capacités parasites.

La demande de brevet PCT WO-A-93/18587 décrit un étage ECL dont la consommation est réglable en fonction de la fréquence de fonctionnement par le réglage du courant de polarisation et des charges de l'étage, de manière que l'excursion reste constante sur la plage des fréquences de fonctionnement. Toutefois, les circuits pour réaliser les réglages sont complexes. Par exemple, un signal de réglage serait un signal numérique fourni par un microprocesseur. Ce signal numérique devrait subir une conversion numérique-analogique avant qu'il puisse agir sur le courant de polarisation ou sur les charges.

Un circuit selon le préambule de la revendication 1 est décrit dans le document EP-A-0 493 150.

Un objet de la présente invention est de réaliser un circuit logique à étage différentiel dont la consommation de courant est adaptable de manière particulièrement simple à la fréquence de fonctionnement, tout en assurant une excursion stable et compatible avec les technologies ECL.

Cet objet est atteint selon l'invention par un étage amplificateur comprenant au moins un transistor MOS de charge en tant que charge réglable, une source de courant de polarisation réglable, et des moyens de réglage pour régler le courant de polarisation en fonction de la fréquence de fonctionnement de l'étage amplificateur et pour commander le transistor de charge de manière que le produit du courant de polarisation par la résistance du transistor de charge soit constant. Les moyens de réglage comprennent un transistor MOS connecté en diode formant un miroir de courant avec ledit transistor de charge ; une pluralité de sources de courant constant de commande susceptibles d'être sélectionnées individuellement par des signaux de sélection respectifs pour polariser le transistor connecté en diode ; et une pluralité de sources de courant constant de polarisation formant ladite source de courant de polarisation réglable, chaque source de courant constant de polarisation étant susceptible d'être sélectionnée par l'un respectif desdits signaux de sélection pour polariser l'étage amplificateur.

Selon un mode de réalisation de la présente invention, la source de courant constant de polarisation et la source de courant de commande associées au même signal de sélection constituent deux sorties d'un même miroir de courant ayant un courant d'entrée prédéterminé qui est commuté par le signal de sélection associé.

Selon un mode de réalisation de la présente invention, l'étage comprend deux transistors connectés en étage différentiel dont le courant de repos est établi par ladite source de courant de polarisation réglable, chaque transistor de l'étage différentiel étant associé à un transistor de charge.

La présente invention vise également un circuit logique comprenant une pluralité d'étages amplificateurs du type susmentionné. Toutes les sources de courant constant de polarisation et toutes les sources de courant de commande associées au même signal de sélection constituent des sorties d'un même miroir de courant ayant un courant d'entrée prédéterminé qui est commuté par le signal de sélection associé.

Ces objets, caractéristiques, avantages ainsi que d'autres de la présente invention seront exposés en détail dans la description suivante de modes de réalisation particuliers, faite à titre non-limitatif à l'aide des figures jointes parmi lesquelles :

la figure 1, précédemment décrite, représente un étage amplificateur différentiel classique ;
la figure 2 représente de façon schématique un étage amplificateur différentiel à consommation réglable ;
la figure 3 représente de manière plus détaillée le circuit de la figure 2, incorporant un mode de réalisation de circuits de réglage selon l'invention ; et
la figure 4 représente un exemple de multiplexeur à étages amplificateurs différentiels à consommation réglable, incorporant un autre mode de réalisation de circuits de réglage selon l'invention.

La figure 2 représente des éléments identiques à ceux de la figure 1, désignés par les mêmes références. Une source de courant de polarisation $I_v$ et les résistances de charge $R_v$ sont réglables et contrôlées par des signaux de commande respectifs $V_i$ et $V_r$ fournis par un circuit de commande 1, lui-même commandé par un signal de sélection S.

Pour chaque fréquence de fonctionnement, on détermine un courant de polarisation $I_v$ minimal, permettant au circuit de fonctionner convenablement à cette fréquence. Chacun de ces courants de polarisation est déterminé par une valeur du signal S, qui est, selon l'invention, un signal numérique fourni sur une pluralité de lignes. En fonction du signal S, le circuit de commande applique des signaux $V_i$ et $V_r$ tels que la valeur de la résistance correspondante $R_v$ soit inversement proportionnelle à la valeur du courant $I_v$. Ainsi, l'excursion de la tension de sortie $\Delta V = R_v.I_v$ reste constante pour toute valeur de $I_v$.

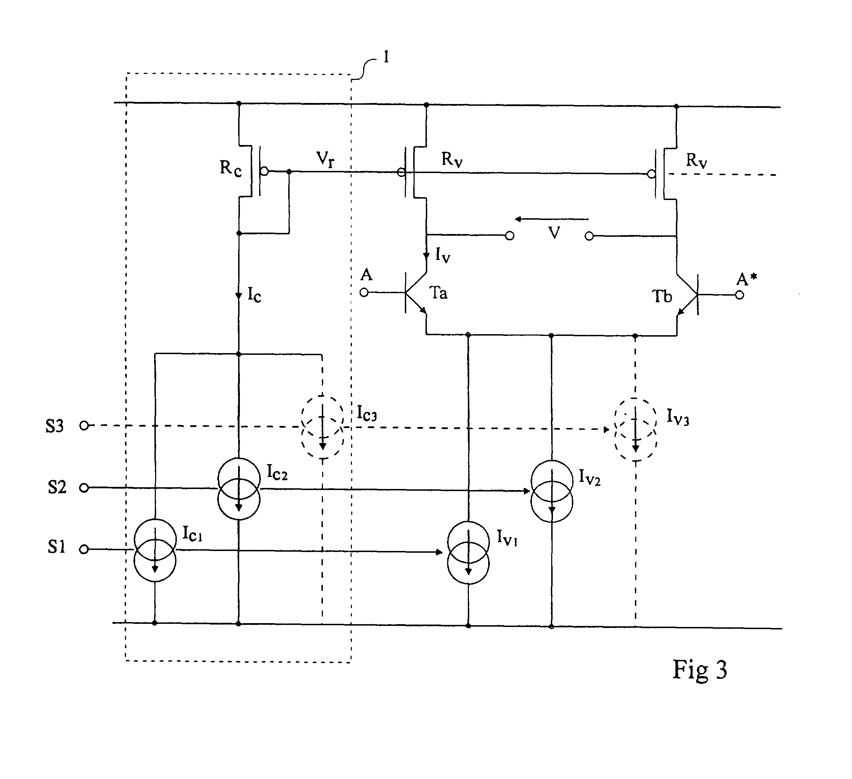

La figure 3 représente un exemple de réalisation des résistances réglables $R_v$, de la source de courant réglable $I_v$ et de leur circuit de commande 1 selon l'invention.

Chacune des résistances de charge $R_v$ est constituée d'un transistor MOS, par exemple à canal P, fonctionnant en zone linéaire, c'est-à-dire en résistance commandée en tension.

Selon l'invention, la source de courant de polarisation $I_v$ comprend plusieurs sources de courant commutables $I_{v1}$, $I_{v2}$, $I_{v3}$..., disposées en parallèle. Chacune de ces sources $I_{vi}$ (i = 1, 2...) est adaptée à l'une des fréquences de fonctionnement souhaitées du circuit et est sélectionnée par un signal de sélection Si associé.

Un mode de réalisation du circuit de commande 1 selon l'invention comprend un transistor MOS $R_c$, par exemple à canal P, connecté en diode, c'est-à-dire que son drain et sa grille sont interconnectés. La source du transistor $R_c$ est reliée au potentiel haut Vcc et son drain est relié à la masse GND par des sources de courant de commande commutables $I_{c1}$, $I_{c2}$, $I_{c3}$..., disposées en parallèle, respectivement associées aux sources $I_{v1}$, $I_{v2}$, $I_{v3}$ et sélectionnées par des mêmes signaux S1,S2,S3,... Le drain du transistor MOS $R_c$ fournit la tension de commande $V_r$ aux grilles des transistors $R_v$. Ainsi, à chaque valeur du courant de polarisation $I_v$, sélectionnée par un signal $S_i$, correspond une valeur de la tension $V_r$, déterminée par le courant de commande $I_c$ sélectionné par le même signal $S_i$. Le transistor $R_c$ fonctionne dans la zone de saturation. La tension $V_r$ qui apparaît entre son drain et sa source est telle que :

$$I_c = K_c.W_c/L_c \cdot (V_r - V_{tc})^2 \qquad (1)$$

où K est le facteur de pente du transistor MOS à canal P, W/L est un facteur de dimension du transistor, et $V_t$ est la tension de pincement du transistor. Les indices c indiquent que ces paramètres sont ceux correspondant à un transistor $R_c$.

Cette tension $V_r$ est appliquée entre la grille et la source des transistors $R_v$. On suppose, pour les explications ci-après, que le courant $I_v$ traverse un seul des transistors $R_v$. La tension qui apparaît entre le drain et la source de ce transistor $R_v$, fonctionnant en zone linéaire, est l'excursion $\Delta V$. Elle est telle que :

$$I_v = 2 \cdot K_v \cdot W_v/L_v \, [\Delta V. (V_r - V_t - \Delta V/2)] \qquad (2)$$

Les paramètres K, W, L et $V_t$ sont ceux définis en relation avec l'équation (1), les indices v indiquant que les paramètres sont ceux correspondant à un transistor $R_v$.

En utilisant les équations (1) et (2) pour trouver une relation entre l'excursion $\Delta V$ et les courants $I_c$ et $I_V$, on obtient :

$$I_c = \frac{K_c \cdot W_c}{L_c} \cdot \left( \frac{L_v}{2K_v \cdot W_v} \cdot \frac{I_v}{\Delta V} + \frac{\Delta V}{2} \right)^2 \qquad (3)$$

Cette relation (3) permet de trouver chaque valeur du courant de commande $I_c$ en fonction de l'excursion $\Delta V$ souhaitée et de chaque courant de polarisation $I_V$ choisi.

On notera que l'étage de commande ($R_c$, $I_{c1}$, $I_{c2}$, $I_{c3}$,...) peut être commun à plusieurs étages d'amplificateurs d'un circuit logique.

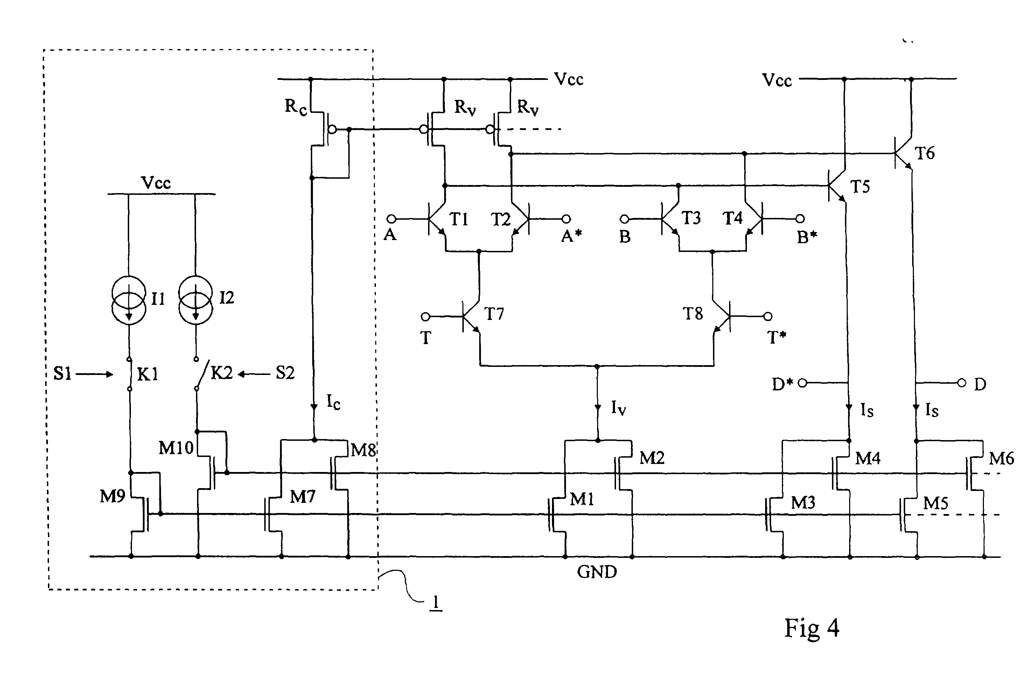

La figure 4 représente un exemple de réalisation de circuit logique multiplexeur avec un autre exemple de résistances et courants de polarisation réglables selon l'invention.

Ce circuit aiguille l'un des signaux d'entrée différentiels A-A* et B-B*, selon l'état d'un signal de commande différentiel T-T*, vers une sortie différentielle D-D*. Il comprend de façon classique trois étages différentiels sur deux niveaux suivis de deux étages suiveurs pour fournir le signal de sortie D-D*.

Les deux étages différentiels du premier niveau sont constitués de transistors bipolaires T1 à T4, chargés par deux transistors MOS à canal P $R_V$ servant de résistances variables. Le drain du premier de ces transistors $R_V$ est connecté à la base d'un transistor bipolaire suiveur T5 et aux collecteurs des transistors bipolaires T1 et T3. Le collecteur du transistor T5 est relié à la tension d'alimentation Vcc et son émetteur constitue la sortie D*. Les bases des transistors T1 et T3 constituent les bornes d'entrée A et B. De façon similaire, le drain du deuxième transistor $R_V$ est relié à la base d'un transistor bipolaire suiveur T6 et aux collecteurs des transistors bipolaires T2 et T4 dont les bases constituent les bornes d'entrée respectives A* et B*. Le collecteur du transistor T6 est relié au potentiel Vcc et son émetteur constitue la sortie D.

Les émetteurs des transistors T1 et T2 sont reliés au collecteur d'un transistor bipolaire T7 dont la base constitue la borne d'entrée T. De même, les émetteurs des transistors T3 et T4 sont reliés au collecteur d'un transistor bipolaire T8 dont la base constitue la borne d'entrée T*. Un courant de polarisation $I_V$ est réparti entre les émetteurs des transistors T7 et T8. Le courant $I_V$ est produit par une source de courant variable constituée de deux transistors MOS à canal N M1 et M2 dont les sources sont reliées à la masse GND et dont les drains sont connectés au point commun des émetteurs des transistors T7 et T8.

Comme cela est représenté, les transistors suiveurs T5 et T6 peuvent être polarisés par un courant $I_s$ variable comme le courant $I_V$, dans le cas où la complexité supplémentaire qui en résulte est compensée par l'économie d'énergie.

Le courant $I_s$ de polarisation du transistor suiveur T5 est fourni par une source de courant comprenant deux transistors MOS à canal N M3 et M4, dont les sources sont reliées à la masse GND et les drains sont connectés à l'émetteur du transistor T5. Le courant $I_s$ de polarisation du transistor suiveur T6 est fourni par une source de courant comprenant deux transistors MOS à canal N M5 et M6 connectés au transistor T6 comme les transistors M3 et M4 au transistor T5.

Dans le circuit de commande 1, un transistor MOS à canal P $R_c$ polarisé par un courant $I_c$ est connecté comme le transistor $R_c$ de la figure 3. La tension de commande $V_r$ est appliquée aux grilles des deux transistors $R_v$ et éventuellement à d'autres transistors homologues associés à d'autres étages différentiels. La source de courant de commande $I_c$ comprend deux transistors MOS à canal N M7 et M8 dont les sources sont connectées à la masse GND et les drains sont connectés au drain du transistor $R_c$.

Les transistors M7, M1, M3 et M5, fonctionnant en zone de saturation, sont des transistors de sortie d'un miroir de courant dont le transistor d'entrée est un transistor MOS à canal N M9, connecté en diode et relié à la masse GND. Une source de courant I1 alimente le transistor M9 et les grilles des transistors M9, M7, M1, M3 et M5 par un interrupteur K1, commandé par un signal de sélection S1.

Les transistors M8, M2, M4 et M6, fonctionnant en zone de saturation, sont des transistors de sortie d'un miroir de courant dont le transistor d'entrée est un transistor MOS à canal N M10, connecté en diode et relié à la masse GND. Une source de courant I2 alimente le transistor M10 et les grilles des transistors M10, M8, M2, M4 et M6 par un interrupteur K2, commandé par un signal de sélection S2.

Si le signal de sélection S1 est actif, l'interrupteur K1 est fermé et la source I1 polarise le transistor M9. Les transistors M7, M1, M3, M5 et éventuellement d'autres transistors homologues associés à d'autres étages différentiels recopient alors sur leurs drains le courant I1 avec des facteurs multiplicatifs respectifs déterminés par les rapports de surface des transistors M7, M1, M3, M5, et du transistor M9. De même, si S2 est actif, ce sont les transistors M8, M2, M4, M6 et d'autres transistors homologues qui recopient sur leurs drains le courant I2 selon d'autres facteurs multiplicatifs appropriés.

En choisissant convenablement le rapport des courants I1 et I2 et/ou les facteurs multiplicatifs, les courants de polarisation $I_v$, $I_s$ et de commande $I_c$ peuvent prendre deux séries de valeurs, telles que l'excursion de la tension de sortie D-D∗ reste constante.

Chacune de ces séries, choisie par la sélection de l'une des sources I1 et I2, est déterminée pour que la consommation soit minimale à la fréquence de fonctionnement associée.

## Revendications

1. Etage amplificateur comprenant au moins un transistor MOS de charge en tant que charge réglable ($R_v$), une source de courant de polarisation réglable ($I_v$), et des moyens de réglage (1) pour régler le courant de polarisation dans le même sens que la fréquence de fonctionnement de l'étage amplificateur et pour commander le transistor de charge de manière que le produit du courant de polarisation par la résistance du transistor de charge soit constant, les moyens de réglage comprenant :

- un transistor MOS connecté en diode ($R_c$) formant un miroir de courant avec ledit transistor de charge ; et
- une pluralité de sources de courant constant de commande ($I_c$) susceptibles d'être sélectionnées individuellement par des signaux de sélection respectifs (S) pour polariser le transistor connecté en diode ;

caractérisé en ce que les moyens de réglage comprennent une pluralité de sources de courant constant de polarisation ($I_v$) formant ladite source de courant de polarisation réglable, chaque source de courant constant de polarisation étant susceptible d'être sélectionnée par l'un respectif desdits signaux de sélection pour polariser l'étage amplificateur.

2. Etage amplificateur selon la revendication 1, caractérisé en ce que la source de courant constant de polarisation ($I_v$) et la source de courant de commande ($I_c$) associées au même signal de sélection constituent deux sorties d'un même miroir de courant ayant un courant d'entrée prédéterminé (I1, I2) qui est commuté par le signal de sélection associé.

3. Etage amplificateur selon la revendication 1, caractérisé en ce qu'il comprend deux transistors (Ta, Tb) connectés en étage différentiel dont le courant de repos est établi par ladite source de courant de polarisation réglable ($I_v$), chaque transistor de l'étage différentiel étant associé à un transistor de charge ($R_v$).

4. Circuit logique comprenant une pluralité d'étages amplificateurs selon la revendication 1 ou 3, caractérisé en ce que toutes les sources de courant constant de polarisation et toutes les sources de courant de commande associées au même signal de sélection constituent des sorties d'un même miroir de courant ayant un courant d'entrée prédéterminé (I1, I2) qui est commuté par le signal de sélection associé.

**Patentansprüche**

1. Verstärkerstufe mit wenigstens einem MOS-Lasttransistor als einstellbar veränderliche Last (Rv), einer einstellbar veränderlichen Vorspannstromquelle (Iv), sowie Einstellmitteln (1) zur Regelung des Vorspannstroms gleichsinnig mit der Betriebs- bzw. Arbeitsfrequenz der Verstärkerstufe sowie zur Steuerung des Lasttransistors derart, daß das Produkt aus Vorspannstrom und Widerstand des Lasttransistors konstant ist, wobei die Einstellmittel umfassen:

- einen als Diode geschalteten MOS-Transistor (Rc), der mit dem genannten Lasttransistor einen Stromspiegel bildet, und
- eine Mehrzahl von Konstant-Steuerstromquellen (Ic), die mittels entsprechender Wählsignale (S) individuell zur Vorspannung des als Diode geschalteten Transistors gewählt werden können;

**dadurch gekennzeichnet**, daß
die Einstellmittel mehrere Konstant-Vorspannstromquellen (Iv) umfassen, welche die genannte einstellbare Vorspannstromquelle bilden, wobei jeweils jede Konstant-Vorspannstromquelle durch ein entsprechendes der Wählsignale zur Vorspannung der Verstärkerstufe gewählt werden kann.

2. Verstärkerstufe nach Anspruch 1, dadurch gekennzeichnet, daß die jeweils zum selben Wählsignal gehörige Konstant-Vorspannnstromquelle (Iv) und Steuerstromquelle (Ic) zwei Ausgänge desselben Stromspiegels mit einem vorgegebenen Eingangsstrom (I1, I2) bilden, der durch das zugehörige Wählsignal umgeschaltet wird.

3. Verstärkerstufe nach Anspruch 1, dadurch gekennzeichnet, daß sie zwei als Differenzstufe geschaltete Transistoren (Ta, Tb) aufweist, deren Ruhestrom durch die genannte einstellbare Vorspannnstromquelle (Iv) eingestellt wird, wobei jeweils jeder Transistor der Differenzstufe einem Lasttransistor (Rv) zugeordnet ist.

4. Logikschaltung mit mehreren Verstärkerstufen nach einem der Ansprüche 1 oder 3, dadurch gekennzeichnet, daß sämtliche zum selben Wählsignal zugeordnete Konstant-Vorspannstromquellen und sämtliche zum selben Wählsignal zugeordnete Steuerstromquellen Ausgänge desselben Stromspiegels mit einem vorgegebenen Eingangsstrom (I1, I2) bilden, der durch das zugeordnete Wählsignal umgeschaltet wird.

**Claims**

1. An amplifier stage including at least one MOS load transistor as an ajustable load (Rv), an adjustable bias current source (Iv), and adjusting means (1) for increasing the bias current with an increase of the operating frequency of the amplifier stage and for controlling the load transistor such that the product of the bias current by the resistance of the load transistor is constant, said adjusting means comprising:

- a diode connected MOS transistor ($R_c$) forming a current mirror with said load transistor; and
- a plurality of constant control current sources ($I_c$), selectable independently by respective selection signals (S) for biasing the diode connected transistor;

characterized in that said adjusting means comprise a plurality of constant bias current sources ($I_v$) forming said adjustable bias current source, each constant bias current source being selectable by a respective one of said selection signals for biasing the amplifier stage.

2. The amplifier stage of claim 1, characterized in that the constant bias current source ($I_v$) and the control current source ($I_c$) associated to a same selection signal are two outputs of a same current mirror having a predetermined input current (I1, I2) that is switched on or off by the associated selection signal.

3. The amplifier stage of claim 1, characterized in that itincludes two transistors (Ta, Tb) connected as a differential stage whose quiescent current is set by said adjustable bias current source ($I_v$), each transistor of the differential stage being associated with one load transistor ($R_v$).

4. A logic circuit including a plurality of amplifier stages according to claim 1 or 3, characterized in that all constant bias current sources and control current sources associated to a same selection signal are outputs of a same current mirror having a predetermined input current (I1, I2) that is switched on or off by the associated selection signal.

Fig 1

Fig 2

Fig 3

8

Fig 4

EP 0 731 562 B1